# FASCICULE DE BREVET EUROPEEN

(11) **EP 1 794 757 B1**
(45) Date de publication et mention de la délivrance du brevet: **15.12.2010**
(21) Numéro de dépôt: 05799852.8
(22) Date de dépôt: 13.09.2005
(51) Int. Cl.: G11C 7/06

(54) **LECTURE DE L'ETAT D'UN ELEMENT DE MEMORISATION NON VOLATILE**
LESEN DES ZUSTANDS EINES NICHTFLÜCHTIGEN SPEICHERELEMENTS
READING OF THE STATE OF A NON-VOLATILE MEMORY ELEMENT

(30) Priorité: 15.09.2004 FR 0452058
(43) Date de publication de la demande: 13.06.2007
(73) Titulaire: STMicroelectronics SA, F-92120 Montrouge (FR)
(72) Inventeur: WUIDART, Sylvie, F-83910 POURRIERES (FR)
(74) Mandataire: de Beaumont, Michel
(86) Numéro de dépôt international: PCT/FR2005/050738
(87) Numéro de publication internationale: WO 2006/030160

(56) Documents cités:
- US-A1- 2004 017 718
- PATENT ABSTRACTS OF JAPAN vol. 2003, no. 12, 5 décembre 2003 (2003-12-05) -& JP 2003 257173 A (NEC CORP), 12 septembre 2003 (2003-09-12) -& US 2005/024950 A1 (SAKIMURA NOBORU ET AL) 3 février 2005 (2005-02-03)

## Description

### Domaine de l'invention

La présente invention concerne, de façon générale, la lecture de l'état d'un élément de mémorisation non volatile et plus particulièrement, la lecture de l'état programmé ou non d'un tel élément.

Un exemple d'application de l'invention concerne la lecture d'un bit stocké de façon non volatile (irréversible ou pas) dans un circuit intégré, par exemple pour conditionner le fonctionnement de tout ou partie du circuit. Il peut s'agir, en particulier, de programmer une fin de mode test d'un circuit intégré de façon à le placer, une fois l'élément programmé, dans un état de fonctionnement normal.

### Exposé de l'art antérieur

On connaît de nombreuses solutions pour réaliser, dans un circuit intégré, un élément de mémorisation à programmation non volatile, c'est-à-dire susceptible de conserver sans alimentation un état ou un autre selon qu'il a ou non été programmé.

Une première famille concerne les éléments fusibles constitués par un oxyde faisant office de condensateur. Quand le condensateur est vierge (non programmé), il n'y a pas de courant de fuite à travers le diélectrique. La programmation consiste à appliquer aux bornes du condensateur une tension suffisamment élevée pour détériorer l'oxyde et créer alors un chemin pour le courant à travers le condensateur. Le changement d'état suite à la programmation est irréversible.

Une deuxième famille concerne les éléments fusibles formés d'une piste conductrice (métallique) qui est interrompue (coupée mécaniquement ou fondue par rayon laser) de façon à programmer l'élément de mémorisation de façon irréversible. Il peut aussi s'agir d'éléments résistifs transformés en circuits ouverts par programmation.

Une troisième famille d'éléments de mémorisation non volatile est constituée de cellules EEPROM ou FLASH, intégrées dans le composant. Le changement d'état suite à la programmation est généralement réversible.

Une quatrième famille concerne des éléments résistifs en silicium polycristallin dont la programmation s'effectue en provoquant une diminution irréversible de la valeur de la résistance en faisant circuler dans l'élément un courant supérieur à un seuil. Ce seuil correspond à un niveau de courant pour lequel la résistance en silicium polycristallin présente une valeur maximum. Cette technique et ses méthodes de programmation sont décrites, par exemple, dans les demandes internationales WO03/06963 et WO03/069656.

Une cinquième famille d'éléments de mémorisation non volatile, réversible, est basée sur la technologique des chalcogénides. Cette technologie est décrite, par exemple, dans l'article "Chalcogenide-Based Non-Volatile Memory Technology" de G. Maimon, E. Spall, R. Quinn et S. Schnur, publié par IEEE en 2001 (0-7803-6599-2/01), et est également connue sous la dénomination commerciale de technologie "OVONYX".

Quel que soit l'élément de mémorisation utilisé, la lecture de l'état de cet élément s'effectue classiquement en mesurant le courant dans l'élément ou la tension à ses bornes afin de comparer la valeur mesurée par rapport à un seuil de courant ou de tension.

Un inconvénient est qu'il est alors nécessaire de disposer de références précises et stables de courant et/ou de tension, et les circuits de génération correspondants prennent de la place sur un circuit intégré.

Un autre inconvénient est que des mesures de courant et/ou de tension sont souvent sensibles aux dispersions technologiques et de fabrication du circuit intégré, et subissent des dérives au cours de la vie du circuit.

Un autre inconvénient des systèmes de lecture d'éléments de mémorisation non volatile (réversible ou non) est que la mesure du courant ou de la tension (plus précisément sa comparaison par rapport à un seuil) requiert une synchronisation par rapport à un signal déclencheur, donc un fonctionnement synchrone. Il en découle un risque de modification du résultat de la comparaison suite à une modification de l'horloge synchronisant la mesure. Un tel inconvénient est particulièrement gênant dans des applications dites sécuritaires, par exemple, quand le contenu dans l'élément de mémorisation conditionne des aspects d'autorisation d'accès à certaines fonctions du composant ou le chiffrement (clé) de données.

Le document JP-2003-257173 décrit un circuit de lecture de l'état d'un élément de mémorisation correspondant au préambule des revendications 1 et 6.

Le document US-A-2004-0017718 décrit un circuit utilisant trois générateurs de tension.

### Résumé de l'invention

La présente invention vise à permettre la lecture de l'état d'un élément de mémorisation non volatile en palliant les inconvénients des systèmes de lecture connus.

L'invention vise notamment à proposer une solution économe, notamment en terme de surface d'intégration dans un circuit pour lire un bit.

L'invention vise également à proposer une solution insensible aux dispersions technologiques ou de fabrication des circuits intégrés.

L'invention vise également à proposer une solution qui puisse s'adapter aisément d'une technologie à une autre.

Dans une application de l'invention où le ou les élément(s) de mémorisation stocke(nt) des états sensibles du point de vue de la sécurité du circuit intégré, l'invention vise également à proposer une solution dans laquelle l'état mémorisé par le circuit est indétectable autrement que par sa lecture.

Pour atteindre ces objets ainsi que d'autres, la présente invention prévoit un procédé de lecture de l'état d'un élément de mémorisation non volatile tel que décrit dans la revendication 1.

Selon un mode de mise en oeuvre de la présente invention, le premier oscillateur déclenche la lecture de l'état du deuxième.

Selon un mode de mise en oeuvre de la présente invention, l'élément de mémorisation est un circuit résistif et capacitif.

Selon un mode de mise en oeuvre de la présente invention, l'élément de mémorisation comporte une résistance programmable par diminution irréversible de sa valeur.

Selon un mode de mise en oeuvre de la présente invention, les fréquences respectives des oscillateurs sont conditionnées par des éléments de même nature.

L'invention prévoit également un circuit de lecture de l'état d'un élément de mémorisation non volatile tel que décrit dans la revendication 6.

Selon un mode de réalisation de la présente invention, le comparateur comporte :
un compteur par oscillateur, les entrées d'horloge respectives des compteurs recevant les signaux fournis par les oscillateurs correspondants ; et
un circuit logique d'analyse de signaux de débordement des compteurs. Brève description des dessins

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 représente, de façon très schématique et sous forme de blocs, un mode de réalisation d'un circuit de lecture de l'état d'un élément de mémorisation non volatile selon la présente invention ;
la figure 2 représente un mode de réalisation détaillé du circuit de la figure 1 ; et
les figures 3A et 3B illustrent, par des chronogrammes, le fonctionnement du circuit de la figure 2.

### Description détaillée

Les mêmes éléments ont été désignés par de mêmes références aux différentes figures. Pour des raisons de clarté, seuls les éléments qui sont utiles à la compréhension de l'invention ont été représentés et seront décrits par la suite. En particulier, la destination de l'état binaire lu par un circuit conforme à l'invention n'a pas été détaillée, l'invention étant compatible avec toutes les applications classiques exploitant un ou plusieurs bits stockés dans un ou plusieurs éléments de façon non volatile.

L'invention sera décrite par la suite en se référant au stockage d'un bit mais elle s'applique plus généralement au stockage de plusieurs bits en dupliquant le circuit de lecture.

Une caractéristique de la présente invention est d'utiliser l'état d'un élément de mémorisation non volatile à lire pour conditionner la fréquence d'un premier oscillateur. De préférence, l'élément de mémorisation non volatile conditionne la valeur d'une cellule résistive et capacitive d'un oscillateur en anneau.

Selon l'invention, la fréquence du premier oscillateur conditionnée par l'état de l'élément à lire est comparée à celle d'au moins un deuxième oscillateur. La fréquence du deuxième oscillateur est prédéterminée et est choisie pour être comprise entre les deux valeurs de fréquence possibles du premier oscillateur en fonction de l'état programmé ou non de l'élément de mémorisation.

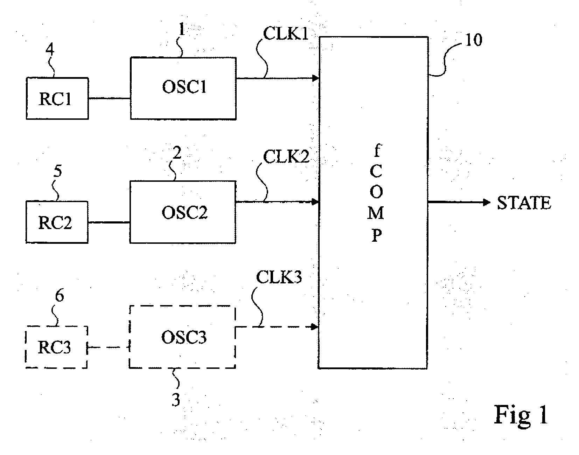

La figure 1 représente, de façon très schématique et sous forme de blocs, un mode de réalisation d'un circuit de lecture de l'état d'un élément de mémorisation non volatile selon l'invention. Le circuit comporte un premier oscillateur 1 (OSC1) fournissant un signal d'horloge CLK1 à un élément 10 (fCOMP) d'analyse de la fréquence du circuit 1. La fréquence du signal d'horloge CLK1 est conditionnée par la valeur d'un circuit résistif et capacitif 4 (RC1). La constante de temps du circuit 4 est fonction de l'état d'un élément de mémorisation non volatile qu'il comporte, de sorte que la fréquence du signal CLK1 est conditionnée par cet élément de mémorisation.

Selon l'invention, le circuit 10 reçoit au moins un deuxième signal d'horloge CLK2 issu d'un deuxième oscillateur 2 (OSC2). La fréquence de l'oscillateur 2 est toutefois, à la différence de celle du premier, prédéterminée. De préférence, la fréquence du signal CLK2 est conditionnée par la valeur d'un circuit 5 (RC2) résistif et capacitif.

Dans une version simplifiée de l'invention, le circuit 10 compare les fréquences respectives des signaux CLK1 et CLK2 pour déterminer un état STATE, fourni par le circuit 10 et qui représente l'état de programmation de l'élément de mémorisation contenu dans le circuit 4.

Selon un mode de réalisation préféré, illustré en pointillés en figure 1, un troisième oscillateur 3 (OSC3) fournit un signal d'horloge additionnel CLK3 au circuit 10. La fréquence de l'oscillateur 3 est, de préférence, conditionnée par un troisième circuit 6 (RC3) résistif et capacitif. La fréquence du signal CLK3 est prédéterminée et est choisie pour être inférieure à la fréquence du signal CLK2 et inférieure à la fréquence du signal CLK1 quel que soit l'état de programmation de l'élément du circuit 4.

La lecture de l'état d'un élément de mémorisation en comparant la fréquence d'un signal d'horloge qu'il conditionne par rapport à une ou plusieurs fréquences prédéterminées présente de nombreux avantages.

Tout d'abord, il n'est pas nécessaire de générer des signaux de référence de tension et de courant pour obtenir le résultat. En effet, en utilisant des signaux d'horloge, la comparaison peut être effectuée directement de façon numérique par le circuit 10 comme cela ressortira mieux de l'exposé des figures suivantes.

Un autre avantage est un gain de place du circuit d'analyse des fréquences par rapport à des comparaisons de tension et de courant. En effet, de simples bascules et portes logiques suffisent pour détecter l'état STATE de programmation de l'élément de mémorisation.

Un autre avantage est, selon le mode de réalisation préféré dans lequel on utilise des cellules résistives et capacitives de même nature, que l'on obtient une auto-adaptation du circuit de lecture en fonction des éventuelles dispersions technologiques et de fabrication. Cette auto-adaptation est également valable en cas de dérive en fonctionnement du circuit.

Un autre avantage, plus particulièrement utile pour des applications dites sécuritaires, est que des éléments de type bascules et portes logiques sont souvent présents en grand nombre dans un circuit intégré, de sorte que les éléments constitutifs du circuit 10 peuvent être "noyés" dans un grand nombre d'éléments similaires, ce qui les rend plus difficilement détectables.

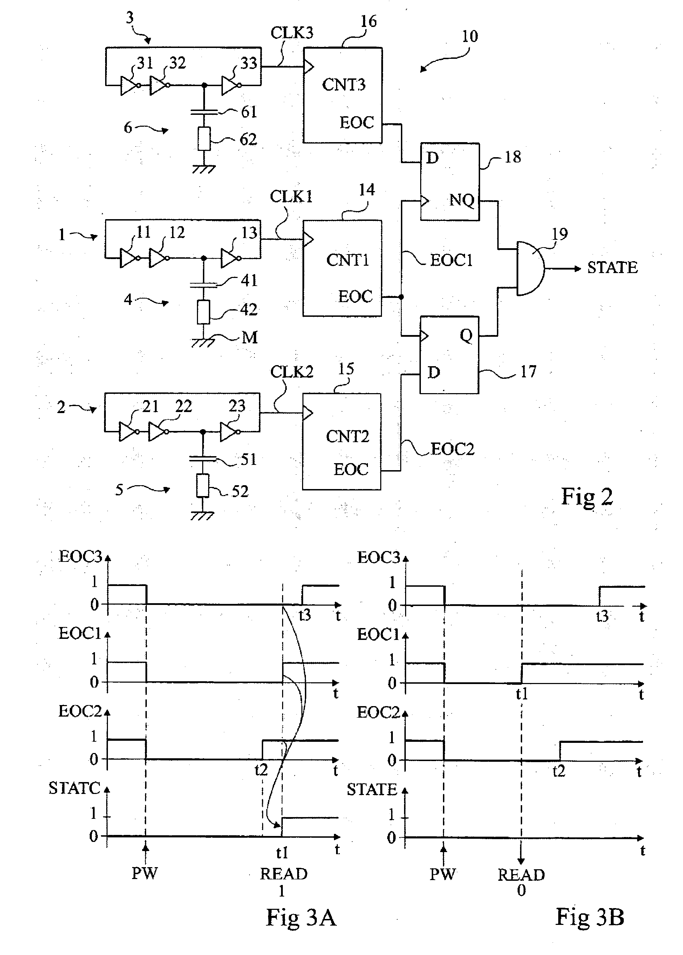

La figure 2 représente un schéma électrique plus détaillé d'un circuit de lecture de l'état d'un élément de mémorisation non volatile. Dans l'exemple de la figure 2, les différents oscillateurs sont constitués d'oscillateurs en anneau comprenant chacun, par exemple, trois inverseurs en série, la sortie du dernière inverseur état rebouclée sur l'entrée du premier. Ainsi, l'oscillateur 1 est constitué de trois inverseurs 11, 12 et 13 en série. La sortie de l'oscillateur 13 est rebouclée sur l'entrée de l'inverseur 11 et définit la sortie de l'oscillateur fournissant le signal CLK1. La fréquence d'oscillation est conditionnée par le circuit résistif et capacitif 4, constitué d'un condensateur 41 en série avec une résistance 42 entre l'entrée de l'inverseur 13 et la masse M.

L'oscillateur 2 (respectivement l'oscillateur 3 s'il est présent) est, de façon similaire, constitué d'inverseurs 21, 22 et 23 (respectivement 31, 32 et 33) en série, la sortie de l'inverseur 23 (respectivement 33) étant reliée à l'entrée de l'inverseur 21 (respectivement 31) et le signal d'horloge CLK2 (respectivement CLK3) étant prélevé en sortie de l'inverseur 23 (respectivement 33). La fréquence d'oscillation de l'oscillateur 2 (respectivement 3) est conditionnée par la constante de temps du circuit 5 (respectivement 6), constitué d'un condensateur 51 en série avec une résistance 61 entre l'entrée de l'inverseur 23 et la masse (respectivement d'un condensateur 61 en série avec une résistance 62 entre l'entrée de l'inverseur 33 et la masse).

D'autres constitutions classiques d'oscillateurs en anneaux sont possibles, en particulier avec des nombres d'inverseurs différents. Toutefois, pour minimiser l'encombrement des oscillateurs, le mode de réalisation de la figure 2 constitue un mode de réalisation préféré.

En figure 2, le circuit 10 comporte trois compteurs numériques 14 (CNT1), 15 (CNT2) et 16 (CNT3) dont les entrées d'horloge respectives reçoivent les signaux CLK1, CLK2 et CLK3. L'invention exploite les signaux de débordement (END OF COUNT) EOC1, EOC2 et EOC3 des compteurs 14, 15 et 16. Fonctionnellement, l'instant d'apparition du signal de fin de comptage ou de débordement dépend de la fréquence du signal d'horloge du compteur correspondant. Le circuit 10 comporte également des éléments logiques de décodage des signaux de débordement.

Dans l'exemple de la figure 2, une première bascule 17 reçoit, sur son entrée de donnée D, le signal EOC2. Une deuxième bascule 18 reçoit, sur son entrée de donnée D, le signal EOC3. Les bascules 17 et 18 reçoivent sur leurs entrées d'horloge respectives le signal EOC1. La sortie non inversée Q de la bascule 17 est combinée avec la sortie inversée NQ de la bascule 18 par une porte logique 19 de type ET qui fournit l'état STATE de programmation de l'élément résistif et capacitif 4. Comme on le verra par la suite, cette programmation peut être effectuée soit au niveau du condensateur 41 soit au niveau de la résistance 42.

Fonctionnellement, le signal EOC1 est utilisé pour déclencher la lecture des états présents en entrée des bascules 17 et 18. Selon les états respectifs des signaux EOC2 et EOC3 à l'instant où le signal EOC1 passe à l'état haut, le résultat fourni par le circuit 10 diffère.

Avec un circuit tel que représenté en figure 2, les oscillateurs 1, 2 et 3 sont actifs dès que le circuit est sous tension (que ce soit une mise sous tension générale ou une commutation particulière).

Le rôle des compteurs 14, 15 et 16 est de fournir une stabilité à la mise sous tension du circuit. La longueur (nombre de bits) des compteurs est choisie en fonction d'un compromis entre la stabilité recherchée et la vitesse de détection. En effet, plus le compteur est sur un nombre de bits important, plus la détection sera retardée par rapport à la mise sous tension mais plus le résultat sera stable. A titre d'exemple de réalisation, des compteurs d'un nombre de bits compris entre 4 et 32 (de préférence, 8) conviendront à la plupart des applications.

Selon un mode de réalisation simplifié, les compteurs sont donc omis et les signaux CLK1, CLK2 et CLK3 attaquent directement les bascules 17 et 18. Un tel mode de réalisation convient pour des fréquences des signaux CLK1, CLK2 et CLK3 suffisamment basses afin d'éviter une oscillation du signal de sortie STATE.

Selon un autre mode de réalisation, on utilise un signal de commande pour réinitialiser les compteurs et provoquer une nouvelle lecture de l'élément de mémorisation.

La figure 3A illustre le fonctionnement du circuit de la figure 2 alors que l'élément de mémorisation 4 est dans un premier état. Cet état est noté indifféremment 0 ou 1 mais correspond à celui où la cellule 4 donne une fréquence d'horloge relativement importante par rapport à celle fournie dans le deuxième état. Ce deuxième état est illustré par la figure 3B.

Dès la mise sous tension (PW), l'ensemble des éléments du circuit 10 sont alimentés. Cela provoque le passage à l'état bas des signaux EOC1, EOC2 et EOC3 (en les supposant actifs à l'état haut). Les compteurs 14, 15 et 16 commencent à compter aux rythmes des signaux d'horloge fournis par les oscillateurs respectifs. De préférence, les signaux EOC fournis par les compteurs correspondent à un même nombre (par exemple, 256 pour un compteur sur 8 bits). En variante, ces nombres seront différents selon les compteurs (par exemple, en prévoyant des compteurs sur des nombres de bits différents), pourvu que cela soit compatible avec les différences entre les fréquences à surveiller.

Dans l'exemple de la figure 3A, le premier compteur à atteindre sa limite est le compteur 15, de sorte que le signal EOC2 passe à l'état haut à un instant t2. Cet instant t1 est le même en figure 3B dans la mesure où la fréquence de l'oscillateur 2 est prédéterminée. De même, dans le mode de réalisation représenté où un troisième oscillateur est utilisé, le signal EOC3 bascule vers l'état haut à un instant t3 quel que soit l'état de programmation de l'élément 4. L'instant t3 est postérieur à l'instant t2 en raison du choix des fréquences des oscillateurs 2 et 3.

Dans le premier cas (figure 3A), l'instant t1 de basculement de signal EOC1 se situe entre les instants t2 et t3. Il en découle un passage à l'état haut du signal STATE à cet instant t1.

Dans le cas de la figure 3B où l'état de programmation de l'élément 4 est différent, l'instant t1 apparaît avant les instants t2 et t3 de sorte que l'état lu est un état bas.

Le fait d'utiliser le signal EOC1 comme horloge d'échantillonnage des deux bascules fournit un circuit de lecture à fonctionnement asynchrone qui ne requiert aucun signal supplémentaire de déclenchement.

Dans le mode de réalisation simplifié où seuls deux oscillateurs sont utilisés, la lecture de l'état de l'élément de mémorisation ne s'effectue de façon certaine que dans un seul sens (basculement vers l'état haut, figure 3A). Ainsi, l'utilisation du troisième oscillateur permet de valider à la fois la lecture d'un état bas et la lecture d'un état haut.

Les différentes techniques classiques de réalisation d'un élément de mémorisation non volatile pourront être mises en oeuvre dans le cadre de l'invention. Toutefois, certaines techniques seront préférées pour apporter des avantages supplémentaires qui seront exposés ci-après.

Un fusible en oxyde faisant office de condensateur (première famille) peut être utilisé pour réaliser le condensateur 41. Dans ce cas, les condensateurs 61 et 51 sont, de préférence, choisis pour avoir les mêmes valeurs que le condensateur 41 non claqué et les différentes valeurs de fréquence d'oscillation sont obtenues par des résistances de valeurs différentes.

Dans le cas d'un élément fusible constitué d'une ligne conductrice coupée à l'assemblage du circuit ou par un rayon laser ultérieurement (deuxième famille), l'élément résistif 42 est préférentiellement constitué d'au moins deux résistances, dont une commutable par l'élément fusible. Les résistances 52 et 62 sont préférentiellement choisies pour être de mêmes valeurs et la différence entre les fréquences d'oscillation est fixée par les valeurs des condensateurs 41, 51 et 61. En variante, on pourra également utiliser un élément résistif 42 qui se trouve cassé (circuit ouvert) par la programmation.

Dans le cas où l'élément de mémorisation est constitué par une cellule de type EEPROM ou FLASH (troisième famille) dont l'état conditionne la fréquence d'oscillation de l'oscillateur 1, cette cellule commute un élément résistif ou capacitif constitutif d'un réseau commutable de l'élément 4. Un avantage du recours à une cellule EEPROM est que sa programmation n'est pas détectable par des moyens optiques dans le circuit, par rapport au recours à des éléments fusibles claquables. Toutefois, la programmation d'une telle cellule requiert des éléments de programmation haute tension par rapport à la tension de fonctionnement.

Selon un mode de réalisation préféré, l'élément résistif 42 et les résistances 52 et 62 sont constitués d'éléments en silicium polycristallin, l'élément 42 étant programmable par diminution irréversible de sa valeur (quatrième famille), ou d'éléments utilisant la technologie basée sur des chalcogénides (cinquième famille).

Un avantage de ces modes de réalisation est qu'ils ne requièrent pas de tension élevée de programmation et que la programmation est non destructrice de l'élément résistif, de sorte qu'elle n'est pas observable. En reprenant l'exemple de la figure 2, les condensateurs 41, 51 et 61 sont choisis de telle sorte que la fréquence de l'oscillateur 1 soit comprise entre les fréquences des oscillateurs 2 et 3 dans le cas d'une résistance non programmée (de valeur relativement élevée) et que la fréquence de l'oscillateur 1 soit supérieure aux fréquences des deux autres oscillateurs dans le cas d'une résistance programmée (valeur relativement faible). On veillera à ce que la dispersion de ces éléments soit inférieure à la variation entre les valeurs de la résistance à l'état vierge ou à l'état programmé. Cette condition ne pose pas de problème en pratique dans la mesure où la dispersion entre les éléments est généralement de l'ordre de 5 % alors qu'il est aisé d'obtenir une variation de la valeur de la résistance en silicium polycristallin de l'ordre de 30 %.

Bien entendu, la présente invention est susceptible de diverses variantes et modifications qui apparaîtront à l'homme de l'art. En particulier, les valeurs à donner aux condensateurs et résistances des cellules résistives et capacitives des oscillateurs en anneau sont à la portée de l'homme du métier à partir des indications fonctionnelles données ci-dessus et en fonction de l'application.

De plus, d'autres circuits d'exploitation des valeurs fréquentielles pourront être prévus, pourvu de respecter un fonctionnement assimilé à un fonctionnement numérique évitant les références de tension et de courant.

En outre, bien que l'invention ait été décrite en relation avec cinq exemples de familles d'éléments de mémorisation possibles, elle s'applique à tout type d'élément de mémorisation pourvu qu'il soit compatible avec un montage dans un circuit où son état conditionne la fréquence d'un signal. Par exemple, l'élément de mémorisation pourra être basé sur une technologie de mémoire magnétique.

Enfin, bien que l'invention ait été décrite en relation avec la mémorisation de deux niveaux (programmé ou non), sa transposition à une mémoire multi-niveaux est à la portée de l'homme du métier en augmentant le nombre d'oscillateurs de fréquences prédéterminées par rapport auxquels comparer la fréquence de l'oscillateur conditionnée par l'état de l'élément de mémorisation.

## Revendications

1. Procédé de lecture de l'état d'un élément de mémorisation non volatile (4), consistant à:
- coupler cet élément à un premier oscillator (1) tel que l'état de cet élément conditionne la fréquence du premier oscillateur (1) ;
- comparer la fréquence du premier oscillateur à la fréquence prédéterminée d'un deuxième oscillateur (2), choisie pour être comprise entre deux valeurs possibles de fréquence du premier oscillateur selon l'état de l'élément de mémorisation, **caractérisé en ce que** le procédé consiste à
- comparer la fréquence du premier oscillateur à celle d'un troisième oscillateur (3) de fréquence inférieure à celle du premier oscillateur dans les états de programmation de l'élément de mémorisation, et inférieure à celle du deuxième oscillateur.

2. procédé selon la revendication 1, dans lequel le premier oscillateur (1) déclenche la lecture de l'état du deuxième (2).

3. Procédé selon la revendication 1, dans lequel l'élément de mémorisation (4) est un circuit résistif (42) et capacitif (41).

4. Procédé selon la revendication 1, dans lequel l'élément de mémorisation (4) comporte une résistance (42) programmable par diminution irréversible de sa valeur.

5. Procédé selon la revendication 1, dans lequel les fréquences respectives des oscillateurs (1, 2, 3) sont conditionnées par des éléments de même nature.

6. Circuit de lecture de l'état d'un élément de mémorisation non volatile (4) comportant :
un premier oscillateur (1) couplé à l'élément de mémorisation et dont la fréquence est conditionnée par l'état de cet élément de mémorisation ;
au moins un deuxième oscillateur (2) dont la fréquence est prédéterminée et est choisie pour être comprise entre les fréquences du premier oscillateur dans deux états de l'élément de mémorisation ;
un comparateur (10) des fréquences respectives des premier et deuxième oscillateurs, **caractérisé en ce qu'**il comporte en outre :
un troisième oscillateur (3) dont la fréquence est prédéterminée et est choisie pour être inférieure à la fréquence du premier oscillateur (1) quel que soit l'état de programmation de l'élément de mémorisation, et inférieure à celle du deuxième oscillateur (2).

7. Circuit selon la revendication 6, dans lequel le comparateur (10) comporte :
un compteur (14, 15, 16) par oscillateur (1, 2, 3), les entrées d'horloge respectives des compteurs recevant les signaux (CLK1, CLK2, CLK3) fournis par les oscillateurs correspondants ; et
un circuit logique (17, 18, 19) d'analyse de signaux (EOC1, EOC2, EOC3) de débordement des compteurs.

## Claims

1. A method for reading the state of a non-volatile storage element (4), consisting of:
- coupling this element to a first oscillator (1), so that the state of this element conditions the frequency of the first oscillator (1); and
- comparing the frequency of the first oscillator with the predetermined frequency of a second oscillator (2), selected to be included between two possible frequency values of the first oscillator according to the state of the storage element, **characterized in that** the method consists of comparing the first oscillator with that of a third oscillator (3) having a frequency smaller than that of the first oscillator in programming states of the storage element, and smaller than that of the second oscillator.

2. The method of claim 1, wherein the first oscillator (1) triggers the reading of the state of the second one (2).

3. The method of claim 1, wherein the storage element (4) is a resistive (42) and capacitive (41) circuit.

4. The method of claim 1, wherein the storage element (4) comprises a resistor (42) programmable by irreversible decrease in its value.

5. The method of claim 1, wherein the respective frequencies of the oscillators (1, 2, 3) are conditioned by elements of same nature.

6. A circuit for reading the state of a non-volatile storage element (4) comprising:
a first oscillator (1) coupled with the storage element and having its frequency conditioned by the state of said storage element;
at least one second oscillator (2) having a predetermined frequency which is selected to be included between the frequencies of the first oscillator in two states of the storage element; and
a comparator (10) of the respective frequencies of the first and second oscillators, **characterized in that** it further comprises:
a third oscillator (3) having a predetermined frequency which is selected to be smaller than the frequency of the first oscillator (1) whatever the programming state of the storage element, and smaller than that of the second oscillator (2).

7. The circuit of claim 6, wherein the comparator (10) comprises:
one counter (14, 15, 16) per oscillator (1, 2, 3), the respective clock inputs of the counters receiving the signals (CLK1, CLK2, CLK3) provided by the corresponding oscillators; and
a logic circuit (17, 18, 19) for analyzing counter overflow signals (EOC1, EOC2, EOC3).

## Patentansprüche

1. Verfahren zum Lesen eines Zustands eines nicht-flüchtigen Speicherelements (4), wobei Folgendes vorgesehen ist:
- Kopplung dieses Elements an einen ersten Oszillator (1) derart, dass der Zustand dieses Elements die Frequenz des ersten Oszillators (1) konditioniert oder einstellt; und
- Vergleichen der Frequenz des ersten Oszillators mit der vorbestimmten Frequenz eines zweiten Oszillators (2), und zwar ausgewählt um eingeschlossen zu sein zwischen zwei möglichen Frequenzwerten des ersten Oszillators gemäß dem Zustand des Speicherelements, **dadurch gekennzeichnet, dass** das Verfahren Folgendes vorsieht: Vergleichen der Frequenz des ersten Oszillators mit der Frequenz eines dritten Oszillators (3), der eine Frequenz besitzt, die kleiner ist als die des ersten Oszillators in Programmierungszuständen des Speicherelements und die kleiner ist als die Frequenz des zweiten Oszillators.

2. Das Verfahren nach Anspruch 1, wobei der erste Oszillator (1) das Lesen des Zustands des zweiten Oszillators (2) auslöst.

3. Das Verfahren nach Anspruch 1, wobei das Speicherelement (4) einen Widerstand (42) und eine Kapazität (41) aufweisende Schaltung ist.

4. Das Verfahren nach Anspruch 1, wobei das Speicherelement (4) einen Widerstand (42) aufweist, der durch eine irreversible Verringerung seines Werts programmierbar ist.

5. Das Verfahren nach Anspruch 1, wobei die entsprechenden Frequenzen der Oszillatoren (1, 2, 3) durch Elemente gleicher Art gebildet oder konditioniert sind.

6. Eine Schaltung zum Lesen des Zustands eines nicht-flüchtigen Speicherelements (4), wobei Folgendes vorgesehen ist:
ein erster Oszillator (1), gekoppelt mit dem Speicherelement und mit seiner Frequenz konditioniert oder bestimmt durch den Zustand des erwähnten Speicherelements;
mindestens ein zweiter Oszillator (2) mit einer vorbestimmten Frequenz,
die ausgewählt ist um eingeschlossen zu sein zwischen den Frequenzen des ersten Oszillators in zwei Zuständen des Speicherelements; und
ein Komparator (10) der entsprechenden Frequenzen der ersten und zweiten Oszillatoren, **dadurch gekennzeichnet, dass** ferner Folgendes vorgesehen ist:
ein dritter Oszillator (3) mit einer vorbestimmten Frequenz, die ausgewählt ist um kleiner zu sein als die Frequenz des ersten Oszillators (1), unabhängig vom Programmierungszustand des Speicherelements und die kleiner ist als die des zweiten Oszillators (2).

7. Die Schaltung nach Anspruch 6, wobei der Komparator (10) Folgendes aufweist:
einen Zähler (14, 15, 16) pro Oszillator (1, 2, 3), wobei die entsprechenden Clock- oder Takteingänge der Zähler die Signale (CLK1, CLK2, CLK3) empfangen, und zwar geliefert durch die entsprechenden Oszillatoren; und
eine Logikschaltung (17, 18, 19) zum Analysieren der Zählerüberlaufsignale (EOC1, EOC2, EOC3).
